# DEMANDE DE BREVET EUROPEEN

(11) **EP 4 746 667 A1**
(43) Date de publication de la demande: **20.05.2026**
(21) Numéro de dépôt: 25214273.2
(22) Date de dépôt: 07.11.2025
(51) Int. Cl.: H10P 10/00

(54) **PROCÉDÉ DE COLLAGE DIRECT DE PLAQUE À PLAQUE**

(30) Priorité: 13.11.2024 FR 2412358
(71) Demandeur: COMMISSARIAT À L'ÉNERGIE ATOMIQUE ET AUX ÉNERGIES ALTERNATIVES, 75015 Paris (FR)
(72) Inventeur: FOURNEL, Franck, 38054 GRENOBLE Cedex 09 (FR); ABADIE, Karine, 38054 GRENOBLE Cedex 09 (FR); MICHAUD, Laurent, 38000 GRENOBLE (FR)
(74) Mandataire: Hautier IP

(57) **Abrégé**

L'invention concerne un procédé de collage direct d'un premier dispositif microélectronique (100) sur un deuxième dispositif microélectronique (200) comprenant une fourniture d'un premier dispositif présentant une première surface (110) plane, et d'un deuxième dispositif présentant une deuxième surface (210) plane, un traitement d'au moins des première et deuxième surfaces par un gaz de plasma comprenant au moins un premier gaz fluoré, présentant un pourcentage atomique F de fluor, un transfert des premier et deuxième dispositifs vers un équipement de collage, une immersion des première et deuxième surfaces dans une atmosphère de collage (1) et un collage des première et deuxième surfaces sous l'atmosphère de collage. Le pourcentage atomique F de fluor et l'humidité relative RH sont contrôlés en synergie de sorte qu'une vitesse de collage Vc soit inférieure ou égale à 15 mm/s et plus spécifiquement inférieure à 10 mm/s.

## Description

### DOMAINE TECHNIQUE

La présente invention concerne l'assemblage de dispositifs microélectronique, notamment pour l'intégration 3D, plus particulièrement le collage direct de plaque à plaque.

### ETAT DE LA TECHNIQUE

Dans le but d'améliorer la densification des transistors dans un dispositif microélectronique, l'avènement de l'intégration 3D apparaît comme une solution prometteuse, permettant d'exploiter la troisième dimension verticale sans forcément faire usage de la miniaturisation des composants. Dans ce cadre, une approche serait de superposer une couche de transistors sur une autre couche de transistors existante. Une autre approche consiste à alimenter les transistors à partir de la face arrière de la zone active, diminuant ainsi les dimensions d'une cellule unitaire. Ces deux approches peuvent être réalisées grâce au collage direct plaque-à-plaque connu en terminologie anglosaxonne sous « Wafer-to-Wafer direct bonding ». Pour avoir accès aux transistors à partir de la face arrière de la zone active, le dispositif est souvent collé à un support pour permettre le retrait du substrat sur lequel les transistors sont formés par amincissement par exemple, donnant ainsi accès aux transistors.

Toutefois, l'étape de collage direct plaque-à-plaque induit souvent des distorsions, qui peuvent compliquer l'alignement lors des étapes suivantes du procédé, comme par exemple, la formation du réseau d'alimentation par lithographie qui nécessite un alignement très précis. De plus, les contraintes résiduelles des étapes précédentes sur les plaques entrainent des défis supplémentaires. Bien que la distorsion brute soit généralement autour de 80 nm, elle peut être réduite autour de 10 nm après correction de l'alignement des plaques et des champs des puces par l'équipement utilisé en lithographie. Cependant, ces valeurs dépassent encore les exigences strictes des nœuds sub-2 nm, nécessitant donc des optimisations supplémentaires.

Il existe donc un besoin consistant à réduire les distorsions lors de l'étape de collage, tout en garantissant une énergie d'adhérence suffisamment élevée pour garantir l'intégrité des plaques jusqu'à la reprise de contact en face arrière en lithographie. Le procédé de collage activé par plasma contenant du fluor est une technique utilisée pour créer des liaisons fortes, donc une bonne adhérence, lors du collage, notamment pour les collages Si/Si. Le document Wang et al. (doi.org/10.1016/j.microrel.2011.09.005) décrit un procédé de collage avec également d'autres matériaux sous un plasma fluoré, tels que les oxydes (SiO₂). Ce document démontre des énergies de collage élevée, de l'ordre de 1,4 J/m² en énergie de surface soit 2,8 J/m² en énergie de collage pour un collage SiO₂/SiO₂. Toutefois, ce document ne traite pas le problème des distorsions lors de l'étape de collage.

La présente invention a pour objectif de résoudre au moins en partie les problèmes mentionnés ci-dessus.

### RESUME

Pour atteindre cet objectif, selon un mode de réalisation on prévoit un procédé de collage direct d'un premier dispositif microélectronique sur un deuxième dispositif microélectronique comprenant les étapes suivantes :
- une fourniture d'un premier dispositif microélectronique présentant une première surface plane, et d'un deuxième dispositif microélectronique présentant une deuxième surface plane,
- un traitement d'au moins une parmi les première et deuxième surfaces par un gaz de plasma comprenant au moins un premier gaz fluoré, présentant un pourcentage atomique F de fluor,
- un transfert des premier et deuxième dispositifs vers un équipement de collage,
- une immersion des première et deuxième surfaces dans une atmosphère de collage présentant une humidité relative RH contrôlée,
- un collage des première et deuxième surfaces disposées l'une en regard de l'autre, à l'aide de l'équipement de collage sous l'atmosphère de collage, dans lequel une adhésion partielle des première et deuxième surfaces est initiée et se propage sous forme d'une onde de collage à une vitesse Vc dite vitesse de collage,
le procédé étant tel que le pourcentage atomique F de fluor lors de l'étape de traitement, et l'humidité relative RH lors de l'étape de collage, sont contrôlés en synergie de sorte que la vitesse de collage Vc soit inférieure ou égale à 15 mm/s. Et suivant, un cas préféré, inférieure à 10 mm/s.

Contrairement à un préjugé qui suggère d'augmenter l'énergie d'adhérence en réalisant un collage rapide, le procédé décrit ci-dessus permet de ralentir la propagation de l'onde de collage grâce au contrôle de la chimie de surface des surfaces à coller et de l'humidité relative RH de l'atmosphère de collage. Une diminution de l'humidité de l'atmosphère de collage associée à une augmentation de la concentration du gaz de plasma en fluor, permettent de ralentir l'onde de collage. Le ralentissement de l'onde de collage joue un rôle important dans la réduction des distorsions induites par le collage direct. Cette réduction de la vitesse de collage est réalisée tout en maintenant une bonne adhérence entre les surfaces des dispositifs, grâce à l'augmentation du pourcentage atomique F de fluor dans le gaz de plasma. En effet, en choisissant un couple (F, RH) convenable, le procédé permet d'atteindre des vitesses de collage inférieures à 15 mm/s et plus préférentiellement inférieure à 10 mm/s, ce qui est relativement lent par rapport aux vitesses de collage standards qui sont de l'ordre de 20 à 50 mm/s. Cette vitesse réduite du collage, permet de réduire significativement les distorsions lors du collage, et d'atteindre des énergies de collage suffisamment élevées ce qui garantit une bonne adhérence des deux surfaces.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1 à 4 illustrent schématiquement, selon une coupe transverse dans un plan xz, différentes étapes d'un procédé de collage direct de deux dispositifs microélectroniques suivant un exemple de réalisation de l'invention.
La figure 5 illustre schématiquement, selon une coupe transverse dans un plan xz, une étape du procédé de collage direct de deux dispositifs microélectroniques suivant un autre exemple de réalisation de l'invention.
Les figures 6 à 10 illustrent schématiquement, selon une coupe transverse dans un plan xz, différentes étapes du procédé de collage direct de deux dispositifs microélectroniques suivant un autre exemple de réalisation de l'invention.
La figure 11A représente une cartographie montrant les distorsions dues à un collage direct de deux plaques selon un procédé différent de celui de la présente invention.
La figure 11B représente des cartographies montrant les distorsions dues à un collage direct de deux plaques selon le procédé de la présente invention.
La figure 12 représente un graphe montrant l'énergie d'adhérence en fonction de la vitesse de collage pour différents cas de collage direct de deux plaques.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le transfert des premier et deuxième dispositifs vers l'équipement de collage est réalisé directement après le traitement par le gaz de plasma sans passer par une étape de nettoyage intermédiaire.

Le transfert direct des dispositifs vers l'équipement de collage, sans passer par une étape de nettoyage après le traitement par le plasma, permet de ralentir davantage la vitesse de collage sans pour autant diminuer largement l'énergie d'adhérence.

Selon une possibilité, le traitement par le gaz de plasma est opéré sur chacune des première et deuxième surfaces. De préférence, on utilise le même gaz de plasma pour traiter chacune des deux surfaces ; mais il est possible d'employer des gaz de plasma différents.

Selon un exemple, l'humidité relative **RH** est supérieure ou égale à 0% et inférieure à 45%.

Selon un exemple, l'humidité relative **RH** est inférieure ou égale à 2%, de préférence inférieure ou égale à 1%.

La réalisation de l'étape de collage se fait souvent dans une salle blanche dont l'humidité relative est de l'ordre de 45%. La présente demande propose de réaliser le collage dans une atmosphère moins humide que celle d'une salle blanche, ce qui permet de réduire significativement la vitesse de collage Vc. Cependant, le ralentissement de l'onde de collage s'accompagne d'une réduction de l'énergie d'adhérence. Afin de compenser l'énergie d'adhérence, le pourcentage atomique F de fluor au cours du traitement par le plasma peut être augmenté.

Selon un exemple, le pourcentage atomique F de fluor est supérieur ou égal à 0,4%.

Selon un exemple, le pourcentage atomique F de fluor est inférieur ou égal à 4%.

Le pourcentage atomique de fluor F peut être augmenté au-delà de la valeur reportée dans le document Wang et al., qui est de l'ordre de 0,4%. Un pourcentage atomique de fluor F=0,4% permet d'obtenir une énergie d'adhérence optimale dans le cadre du procédé de Wang et al. Cependant, pour une telle valeur de F, la vitesse de collage Vc n'est pas affectée et est de l'ordre de 30 mm/s ce qui est relativement rapide. Une diminution de l'humidité relative associée à une augmentation du pourcentage atomique de fluor au-delà de 0,4%, permet de réduire la vitesse de collage, tout en garantissant une bonne énergie d'adhérence grâce à la présence du fluor dans le traitement des surfaces de collage par le plasma fluoré.

Selon un exemple, l'équipement de collage comprend une chambre de collage dans laquelle les premier (100) et deuxième (200) dispositifs sont insérés lors de l'étape de transfert, et l'immersion des première et deuxième surfaces dans l'atmosphère de collage comprend une injection d'un flux d'un troisième gaz dit de collage dans la chambre de collage, de sorte que le gaz de collage soit confiné dans la chambre de collage formant ainsi l'atmosphère de collage.

La réalisation de l'étape de collage dans une chambre, permet d'une part de réduire les contaminants qui peuvent être présent dans l'atmosphère de collage, et d'autre part de mieux contrôler l'humidité relative dans un espace restreint.

Selon un exemple, l'immersion des première et deuxième surfaces dans l'atmosphère de collage comprend une injection d'un flux d'un troisième gaz dit de collage de sorte que le gaz de collage remplisse au moins une région entre les première et deuxième surfaces disposées l'une en regard de l'autre, formant ainsi l'atmosphère de collage.

Selon un exemple, lequel le gaz de collage consiste en, ou est un mélange comprenant au moins un des gaz suivants : He, CO2, N2, O2, Ne, Ar, CF₄, SF₆, NF3 et H₂. L'utilisation d'un gaz à parcours libre moyen court pour former l'atmosphère de collage permet de ralentir l'onde de collage (par exemple le CO2).

Selon un exemple, le premier gaz consiste en, ou est un mélange comprenant au moins un des gaz suivants : SF₆, CF₄, NF3 et F2.

Selon un exemple, le gaz de plasma comprend un deuxième gaz consistant en, ou étant un mélange comprenant au moins un des gaz suivants : N₂, O₂, Ar et He.

Selon un exemple, le procédé comprend en outre un traitement thermique des première et deuxième surfaces avant le collage, le traitement permettant de porter la première et la deuxième surfaces à une température supérieure ou égale à 20°C et/ou inférieure ou égale à150°C, de préférence inférieure ou égale à 50°C. Augmenter la température des surfaces avant collage permet de ralentir l'onde de collage.

Selon un exemple, le premier dispositif est une plaque comprenant un premier empilement, ledit premier empilement comprenant au moins un transistor et étant en contact avec la première surface, et le deuxième dispositif est une plaque comprenant un deuxième empilement, ledit deuxième empilement comprenant au moins un transistor et étant en contact avec la deuxième surface.

Ce procédé permet d'assembler par collage direct deux couches de transistors selon la troisième direction verticale, avec le moins de distorsions entre les deux couches, ce qui améliore l'alignement global des deux surface, et facilite les étapes de fabrication post-collage.

Selon un exemple, le premier dispositif est une plaque comprenant un premier empilement sur un substrat, ledit premier empilement comprenant au moins un transistor et étant en contact avec la première surface, le substrat étant destiné à être retiré suite au collage, et le deuxième dispositif est une plaque comprenant au moins une couche de support en contact avec la deuxième surface.

Ce procédé permet également de reporter par collage direct sur une couche de support, une couche de transistors formée sur un substrat, pour ensuite retirer le substrat et former un réseau d'alimentation des transistors à partir de la face arrière de l'empilement. Un avantage du procédé réside dans le fait que ce report peut être réalisé en réduisant effectivement les distorsions des surfaces ce qui facilite les étapes de lithographie post-collage, notamment l'alignement des marqueurs.

Selon un exemple, au moins l'une des première et deuxième surfaces est à base d'un matériau semiconducteur, d'un oxyde, d'un métal, ou encore comprend au moins une zone à base d'un oxyde et une zone à base d'un métal ou d'un semiconducteur.

Le procédé permet non seulement un collage de surfaces en silicium, mais également le collage de surfaces oxydes, tout en réduisant les distorsions. En effet, pour un collage hydrophobe Si/Si la vitesse de collage est réduite, mais ce procédé permet de coller des surfaces oxydes avec une vitesse de collage encore plus réduite ou équivalente.

Dans le cadre de la présente invention, un procédé de report et de collage appliqué au collage d'une plaque sur une plaque est décrit. Ce procédé peut s'étendre au collage d'une ou plusieurs puces sur une plaque ou le collage d'une puce sur une puce. Ce procédé est préférentiellement destiné à une mise en œuvre industrielle, pour reporter et coller une plaque sur une plaque. Il appartient au domaine du collage direct. Ce collage direct peut être un collage hybride. « Hybride » signifie que les surfaces de collage sont composées d'au moins deux matériaux. « Direct » signifie que l'interface de collage correspond, après collage définitif, directement aux deux surfaces de collage, sans qu'il y ait de couche de collage, comme une colle polymère, intercalée entre les deux surfaces de collage. Le collage direct est aussi un collage spontané, qui se propage donc tout seul sans appui extérieur. Ce n'est pas par exemple de la thermocompression.

Dans la présente demande, une « plaque » ou « wafer » désigne typiquement un substrat, comprenant ou portant une pluralité de puces. Une plaque peut être dépourvue de composants. Une « puce » désigne typiquement un circuit intégré comprenant des composants microélectroniques ou optoélectroniques ou encore des microsystèmes électromécaniques (MEMS). L'alignement peut se faire avec des marques d'alignement, simplement avec la précision de déplacement de la machine ou avec l'aide de butées mécaniques qui utilisent le bord des substrats.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants.

Les étapes du procédé s'entendent au sens large de la réalisation d'une partie du procédé et peuvent éventuellement être réalisées en plusieurs sous-étapes. Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Les valeurs dimensionnelles s'entendent aux tolérances de fabrication et de mesure près.

Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale à un plan signifie une direction présentant un angle de 90±10° par rapport au plan.

Un repère de préférence orthonormé, comprenant les axes x, y, z est représenté sur les figures annexées.

L'épaisseur d'une couche ou du substrat se mesure selon une direction perpendiculaire à la surface selon laquelle cette couche ou ce substrat présente son extension maximale. L'épaisseur est ainsi prise selon une direction perpendiculaire aux faces principales de la couche ou du substrat sur lequel repose les différentes couches. Plus particulièrement, l'épaisseur peut être prise selon la direction z.

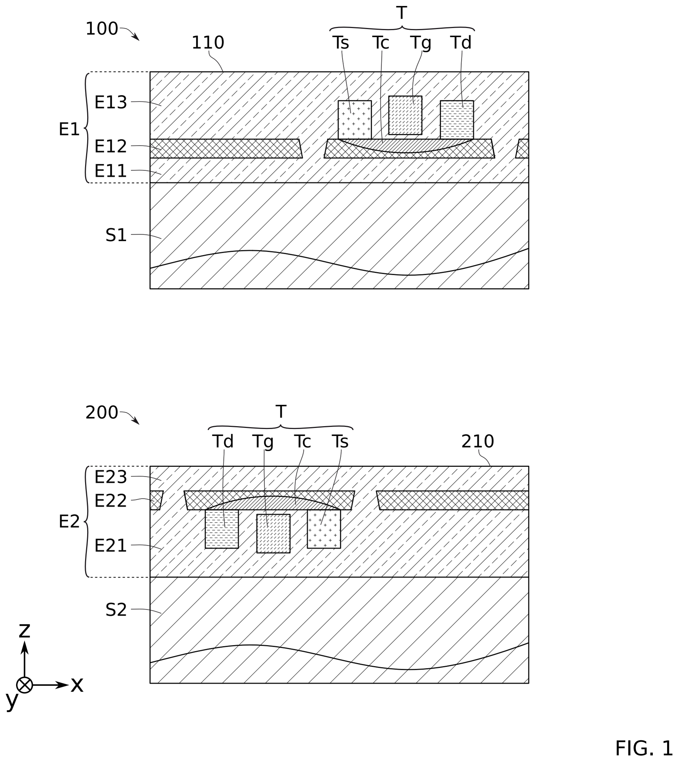

Le procédé d'assemblage de deux dispositifs microélectroniques par collage direct est maintenant décrit en référence aux figures 1 à 4.

Comme illustré à la figure 1, le procédé comprend une fourniture d'un premier dispositif microélectronique 100 et d'un deuxième dispositif microélectronique 200. Le premier dispositif 100 peut comprendre un premier substrat S1 s'étendant dans un plan xy horizontal, défini par une direction x et une direction y perpendiculaire à la direction x. Le premier substrat S1 est surmonté d'un premier empilement E1 d'au moins une couche suivant une direction z perpendiculaire aux directions x et y. Le premier dispositif 100 présente une première surface 110 plane, dite première surface de collage. Cette première surface 110 correspond à la face exposée du premier empilement E1.

Le deuxième dispositif 200 peut comprendre un deuxième substrat S2 s'étendant dans le plan xy, et surmonté d'un deuxième empilement E2 d'au moins une couche suivant la direction z. Le deuxième dispositif 200 présente une deuxième surface 210 plane, dite deuxième surface de collage. Cette deuxième surface 210 correspond à la face exposée du deuxième empilement E2.

Les première 110 et deuxième 210 surfaces de collage, sont destinées à être collées l'une sur l'autre par collage direct afin d'assembler les premier 100 et deuxième 200 dispositifs suivant la direction z. Avant l'étape de collage, le procédé comprend un traitement des première 110 et deuxième 210 surfaces de collage par un gaz de plasma fluoré. Le gaz de plasma comprend au moins un premier gaz comprenant du fluor. Le gaz de plasma peut comprendre un deuxième gaz ou une pluralité de gaz mélangés au premier gaz comprenant du fluor. Le gaz de plasma présente un pourcentage atomique F de fluor. Ce traitement des surfaces de collage par le gaz de plasma fluoré, permet de réduire l'énergie d'adhésion du collage direct. La vitesse de l'onde de collage est ainsi réduite. Le traitement des surfaces par le plasma fluoré permet, a contrario, d'augmenter l'énergie d'adhérence des surfaces de collage après un recuit de consolidation. Cette énergie d'adhérence dépend de la concentration du gaz de plasma en fluor, ou bien du pourcentage atomique F du gaz de plasma.

Suite au traitement des première 110 et deuxième 210 surfaces de collage par le plasma fluoré, le procédé comprend un transfert des premier 100 et deuxième 200 dispositifs vers un équipement de collage 20. L'équipement de collage 20 permet de manipuler les dispositifs, de les aligner l'un par rapport à l'autre, et de les assembler par collage direct.

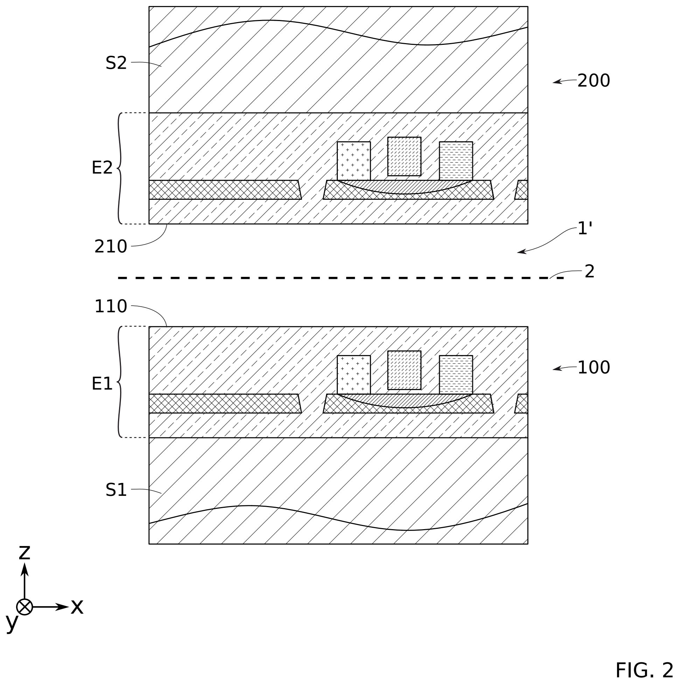

Comme illustré à la figure 2, les première 110 et deuxième 210 surfaces sont disposées l'une en regard de l'autre, par rapport à une interface de collage 2, de préférence parallèle au plan xy. L'alignement des deux surfaces 110, 210, peut se faire dans des plans parallèles à l'interface de collage 2 et disposés d'une part et d'autre de l'interface de collage 2. Les deux surfaces de collage 110, 210, séparées et disposées l'une en face de l'autre avant le collage, définissent une région 1'.

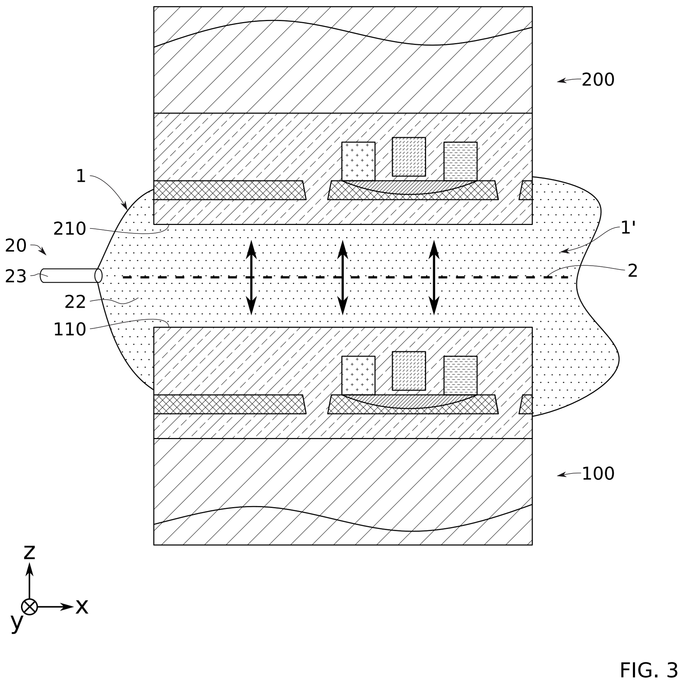

Comme illustré à la figure 3, avant de réaliser l'étape de collage, le procédé comprend une immersion des première 110 et deuxième 210 surfaces de collage dans une atmosphère de collage 1. L'atmosphère de collage 1 peut être formée en injectant un flux d'un troisième gaz 22 dit de collage, notamment dans la région 1', de sorte que les surfaces de collage 110, 210, soient immergées dans ce gaz 22, formant ainsi l'atmosphère de collage 1. L'équipement de collage 20 peut comprendre au moins un injecteur 23 de gaz relié à un réservoir de gaz de collage, et permettant d'injecter le gaz de collage 22. L'injecteur 23 de gaz peut être équipé d'un premier capteur et d'une vanne permettant de surveiller et d'ajuster le débit du gaz de collage 22.

L'atmosphère de collage 1 présente une humidité relative notée RH. L'humidité relative RH de l'atmosphère de collage 1 est contrôlée, de préférence, avant et le long de l'étape de collage. En effet, le gaz de collage 22 injecté dans la région 1', permet de remplacer l'air présent dans cette région 1' qui contient généralement de l'humidité. Ainsi, en remplaçant l'air par le gaz de collage 22, qui est de préférence sec, l'humidité relative RH de l'atmosphère de collage 1 diminue progressivement jusqu'à atteindre une certaine valeur stable avant le collage. Cette valeur de RH est de préférence maintenue fixe, jusqu'à ce que le collage soit terminé.

L'équipement de collage 20 peut comprendre par exemple un deuxième capteur tel qu'un hygromètre, permettant de mesurer l'humidité relative RH de l'atmosphère de collage 1. Ce deuxième capteur peut être connecté à un système de contrôle par exemple, qui permet de régulariser l'humidité relative RH en temps réel. Cela peut être réalisé en connectant le premier capteur et la vanne de l'injecteur 23 au système de contrôle ce qui permet d'avoir une boucle de rétroaction, afin d'ajuster le débit du gaz de collage 22 en fonction de l'humidité relative RH mesurée dans l'atmosphère de collage 1.

Ce contrôle de l'humidité relative de l'atmosphère de collage 1 permet de former une atmosphère de collage 1 plus sèche par rapport à l'atmosphère ambiante, ou l'atmosphère d'une salle blanche dans laquelle le collage direct est typiquement réalisé.

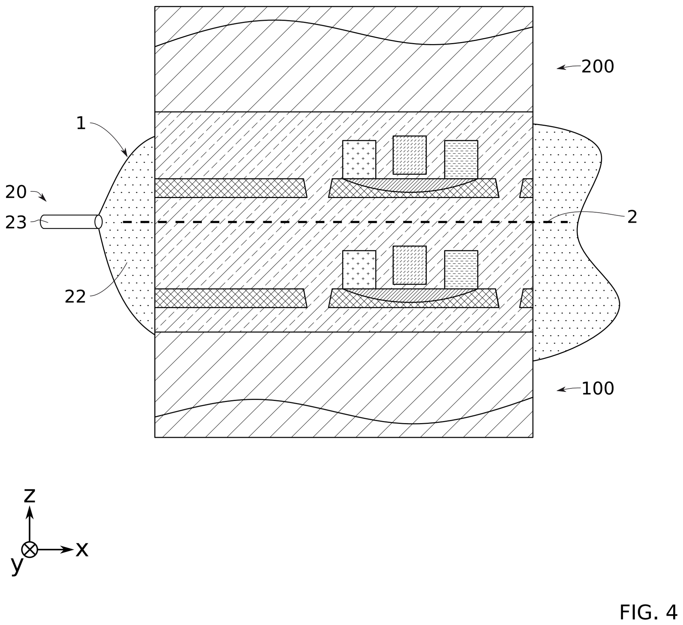

Comme illustré à la figure 4, le procédé comprend un collage des première 110 et deuxième 210 surfaces en les rapprochant l'une de l'autre au niveau de l'interface de collage 2 avec une distance inférieure à 500 µm ou plus préférentiellement inférieure à 100 µm voire même à 50 µm. Il est aussi possible de juste laisser tomber la surface du dessus sur celle du dessous. Le film d'air de l'atmosphère de collage qui se retrouve piégé entre les surfaces assure automatiquement une séparation avec une distance inférieure à environ 100µm au bout de quelques secondes, voire même en dessous de 10 µm. L'interface de collage 2 constitue un plan qui comprend à la fois les première 110 et deuxième 210 surfaces. Le collage des deux surfaces 110, 210, est réalisé sous l'atmosphère de collage 1. Lorsque les deux surfaces 110, 210, sont rapprochées tel que décrit ci-dessus, une adhésion partielle est initiée à au moins une zone dans le plan de l'interface de collage 2, comme le centre d'une surface de collage par exemple. Cette initiation se réalise en mettant en contact physique les surfaces localement. Ceci peut se faire au moyen d'une pointe de collage. Cette adhésion partielle se propage ensuite radialement dans le plan de l'interface de collage 2 à partir du centre jusqu'aux bords des surfaces de collage, sous forme d'une onde connue sous l'onde de collage et ce même si la point de collage est retirée. C'est en cela que l'on parle de collage spontané. Il y a une auto-propagation de l'adhésion. Dans le cas où la surface du dessus est simplement lâchée au-dessus de celle du dessous et que la séparation est assurée par un film d'air, il est possible de laisser faire la gravité pour obtenir le collage spontané. On ne maîtrise en revanche alors pas le point d'initiation, qui peut être, en outre, multiple. Cette onde de collage est caractérisée par une vitesse de collage Vc qui affecte la qualité de collage. Plus l'onde de collage est rapide, c'est-à-dire plus la vitesse de collage Vc est importante, plus les distorsions dues au collage sont importantes. Les distorsions sont des déformations mécaniques le long de l'interface de collage. Les distorsions résultant d'un collage direct sont généralement aléatoires et difficiles à compenser par des modèles numériques lors d'un alignement des marqueurs pour réaliser une lithographie par exemple.

En réduisant la vitesse de collage Vc, les distorsions dues au collage sont significativement réduites. L'atmosphère de collage 1 sèche permet de réduire la vitesse de collage. En revanche, cette réduction de la vitesse de collage s'accompagne généralement d'une réduction de l'énergie d'adhérence des surfaces de collages ce qui n'est pas souhaitable. Une bonne adhérence des surfaces de collages est importante car elle permet de garantir une bonne stabilité mécanique de l'assemblage, notamment lors des étapes de fabrication post-collage.

Pour compenser la faiblesse de l'énergie d'adhérence, le pourcentage atomique F du fluor est réduite lors de l'étape du traitement par le plasma fluoré, synergétiquement à la réduction de l'humidité relative RH de l'atmosphère de collage 1 lors de l'étape de collage. En variant ces deux paramètres, un couple (F, RH) peut être choisi de sorte à ralentir la vitesse de collage considérablement lors du collage, tout en garantissant une bonne adhérence des surfaces de collage. On obtient donc, grâce à ce contrôle synergique des paramètres F et RH, une vitesse de collage Vc inférieure ou égale à 15 mm/s et plus préférentiellement inférieure à 10 mm/s. Une telle vitesse de collage Vc permet la réduction des distorsions dues au collage. D'autre part, grâce à ce contrôle synergique des paramètres F et RH, le collage permet d'obtenir une énergie d'adhérence suffisamment élevée pour la production d'assemblages de dispositifs microélectroniques.

Le pourcentage atomique F du fluor présent dans le gaz de plasma, peut être supérieur ou égal à 0,4%. Pour une valeur de F qui est proche de 0,4%, l'effet de la concentration du fluor dans le plasma sur la vitesse de collage est négligeable. Dans ce cas-là, l'humidité relative RH de l'atmosphère de collage doit être fortement diminuée. Afin d'affecter, notamment réduire, la vitesse de collage Vc, le pourcentage atomique F est avantageusement augmenté au-delà de 0,4%. Une forte augmentation de F peut s'accompagner d'une diminution modérée de RH. Similairement, une forte diminution de RH peut s'accompagner d'une augmentation modérée de F. De préférence, le pourcentage atomique F est inférieur ou égale à 4%. En effet, au-delà de 4% le collage des deux surfaces 110, 210 est compromis.

L'humidité relative RH de l'atmosphère de collage 1 lors de l'étape de collage est avantageusement strictement inférieure à 45%. L'humidité relative RH de l'atmosphère de collage 1 peut être idéalement nulle, ou légèrement supérieure à 0% lors de l'étape de collage. Selon un exemple, l'humidité relative RH est contrôlée de sorte qu'elle soit inférieure ou égale à 10%, de préférence inférieure ou égale 2%, plus préférentiellement, inférieure ou égale à 1%.

Une approche complémentaire à la variation conjointe des paramètres F et RH, permettant de réduire la vitesse de collage Vc, consiste à omettre une étape de nettoyage, notamment chimique, des surfaces de collages 110, 210 suite au traitement des surfaces par le plasme fluoré. En effet, selon cet exemple de réalisation, le transfert des premier et deuxième dispositifs 100, 200, vers l'équipement de collage 20 se fait directement après le traitement par le plasma. Ce transfert peut se faire sous l'atmosphère de la salle blanche par exemple.

Comme illustré aux figures 3 et 4, selon une variante, l'immersion des première 110 et deuxième 210 surfaces dans l'atmosphère de collage 1, peut se faire dans un espace non confiné, c'est-à-dire un espace qui n'est pas strictement clos comme une chambre de collage. Selon cette variante, l'injecteur 23 de gaz peut être disposé au niveau de la région 1', de sorte que le gaz de collage 22 injecté, remplisse au moins la région 1' formant ainsi l'atmosphère de collage 1. L'atmosphère de collage 1 ou le gaz de collage 22 peuvent s'étendre au-delà de la région 1', tant que les surfaces de collages 110, 210, et la région 1' sont immergées dans le gaz de collage. L'atmosphère de collage peut inclure une partie ou bien l'intégralité des premier et deuxième dispositifs. Selon cette variante, le gaz de collage 22 n'est pas nécessairement confiné. Le collage peut être réalisé sous une atmosphère de collage 1 formée localement par le gaz de collage, au sein d'une salle blanche par exemple.

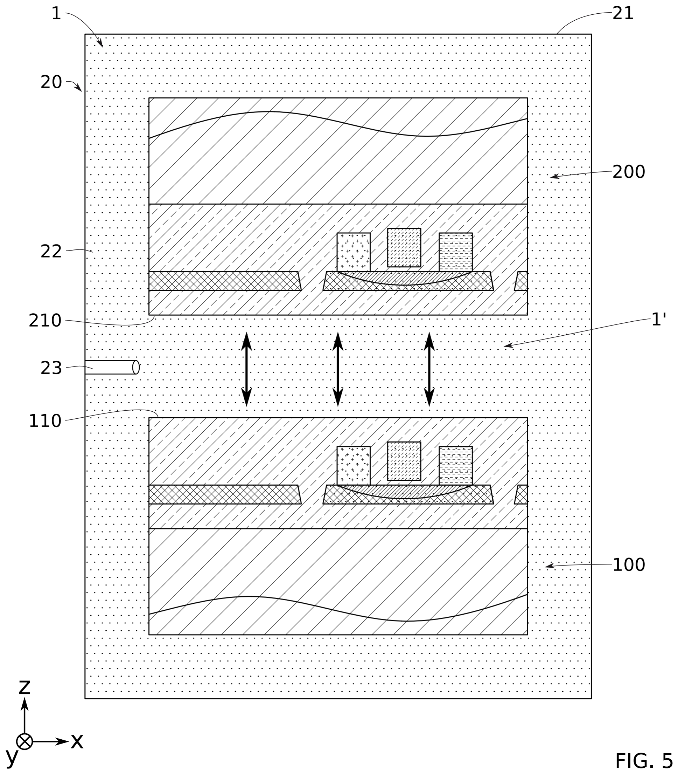

Comme illustré à la figure 5, selon une autre variante, l'équipement de collage 20 peut comprendre une chambre de collage 21. Selon cette variante, suite au traitement des surfaces de collage par le plasma, les dispositif 100, 200, sont insérés dans la chambre de collage 21 de sorte que la chambre 21 enferme intégralement les dispositifs 100, 200, formant ainsi un espace confiné. L'injecteur 23 du gaz de collage 22 est disposé à l'intérieur de cette chambre de collage 21. L'injecteur 23 peut être disposé au niveau de la région 1', ou dans un autre endroit à l'intérieur de la chambre de collage 21. L'immersion des surfaces de collage 110, 210, dans l'atmosphère de collage 1, comprend ainsi une injection du gaz de collage 22 à l'intérieure de la chambre de collage 21 pour former l'atmosphère de collage 1. Selon un exemple, l'air ambient confiné dans la chambre de collage avant la formation de l'atmosphère de collage 1, peut être retiré de la chambre de collage progressivement lors de l'injection du gaz de collage 22 qui vient le remplacer, ou complètement avant l'injection du gaz de collage 22. Le gaz de collage 22 s'étend dans toute la chambre de collage 21, et notamment dans la région 1' entre les surfaces de collage 110, 210. L'utilisation d'une chambre de collage 21 permet de diminuer la présence des contaminants lors du collage. Cela est avantageux dans le cadre d'un procédé de collage dans lequel le nettoyage des surfaces après le traitement par le plasma n'est pas réalisé.

Comme illustré aux figures 1 à 5, le procédé décrit ci-dessus permet d'assembler par exemple deux plaques par collage direct. Le premier dispositif 100 peut être une première plaque comprenant un premier substrat S1 sur lequel un premier empilement E1 est formé. Le premier empilement E1 peut comprendre une première couche de support E11 à base d'oxyde de silicium dite « BOX » (Burried Oxide), surmontée d'une première couche active E12 à base de silicium par exemple, comprenant au moins un, de préférence plusieurs transistors T. L'empilement E1 peut comprendre en outre une couche de protection E13 à base de SiO₂ dont la face exposée n'est autre que la première surface 110 de collage. Chaque transistor T comprend une source Ts, un drain Td et une grille Tg qui peuvent être intégrés dans la couche de protection E13, et un canal Tc intégré dans la couche active E12.

Le deuxième dispositif 200 peut être une deuxième plaque comprenant un deuxième substrat S2, sur lequel un deuxième empilement E2 est formé. L'empilement E2 peut également comprendre une deuxième couche de support E21 à base d'oxyde de silicium (BOX), surmontée d'une deuxième couche active E22 à base de Si, comprenant au moins un, de préférence plusieurs transistors T. L'empilement E2 peut comprendre en outre une couche de protection E23 à base de SiO₂, dont la face exposée n'est autre que la deuxième surface 210 de collage. Chaque transistor T comprend une source Ts, un drain Td et une grille Tg qui peuvent être intégrée dans la couche de protection E23, et un canal Tc intégré dans la couche active E22.

Comme illustré à la figure 4, ces deux plaques peuvent être assemblées par collage direct selon la direction z, à l'aide du procédé de la présente invention. Cet assemblage permet d'augmenter la densité des transistors en superposant verticalement deux couches actives comprenant des transistors. Un avantage de ce procédé est de réaliser le collage avec moins de distorsions garantissant un meilleur alignement entre les deux plaques, ce qui permet de faciliter les procédés post-collage et d'obtenir des assemblages microélectroniques à l'échelle industrielle.

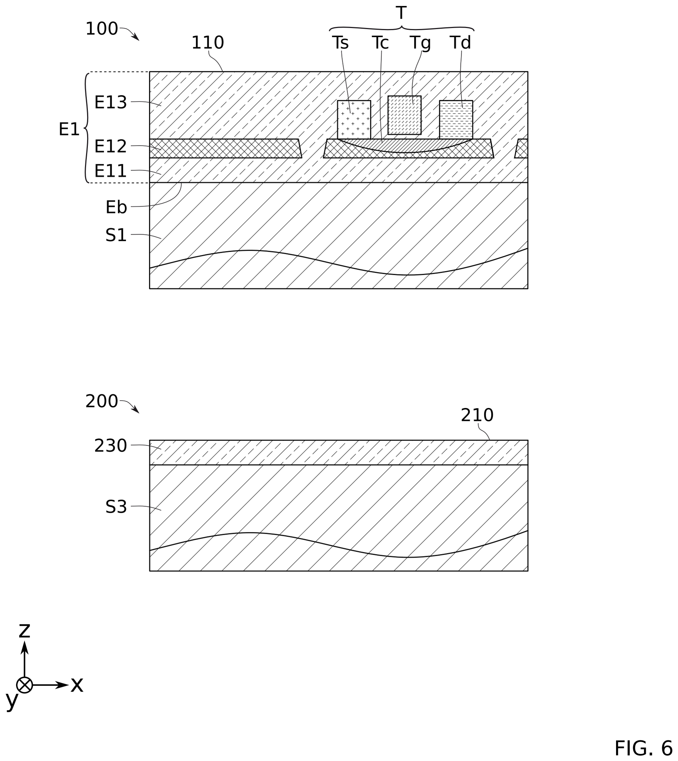

Les figures 6 à 10 illustrent un autre exemple d'application du procédé de la présente invention. Selon cet exemple, comme illustré à la figure 6, le premier dispositif 100 peut être une première plaque identique à celle décrite précédemment. Le deuxième dispositif 200 peut être une troisième plaque dite de support (poignée) ou « carrier wafer » en anglais, comprenant un troisième substrat S3 et une troisième couche de support 230 à base de SiO₂ par exemple, formée sur le substrat S3. La troisième couche de support 230 présente une face exposée qui n'est autre que la deuxième surface 210 de collage. La troisième couche de support 230 peut ne pas comprendre de composants électroniques ou de sous-couches actives et servir uniquement pour le support de la première plaque.

La première plaque peut être reportée sur la plaque de support par collage direct à l'aide du procédé de la présente invention.

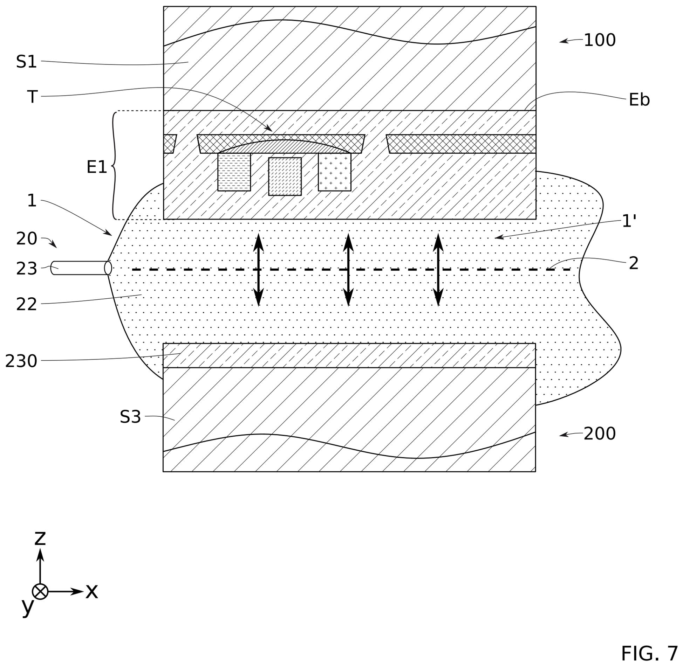

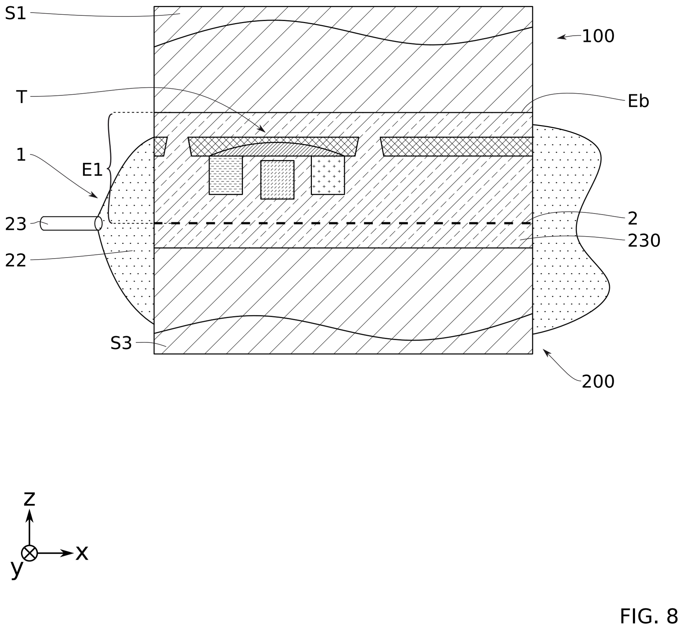

Comme illustré à la figure 7, suite au traitement des surfaces de collage par le plasma fluoré, la première plaque est retournée et alignée relativement à la plaque de support, de sorte que les première 110 et deuxième 210 faces de collage soient disposées l'une en regard de l'autre. Les faces de collages 110, 210, sont ensuite immergées dans l'atmosphère de collage 1, pour être ensuite mise en contact lors de l'étape de collage tel qu'illustré à la figure 8. Le présent procédé permet de reporter la plaque comprenant les transistors, en limitant les distorsions de la première face de collage dues au collage direct.

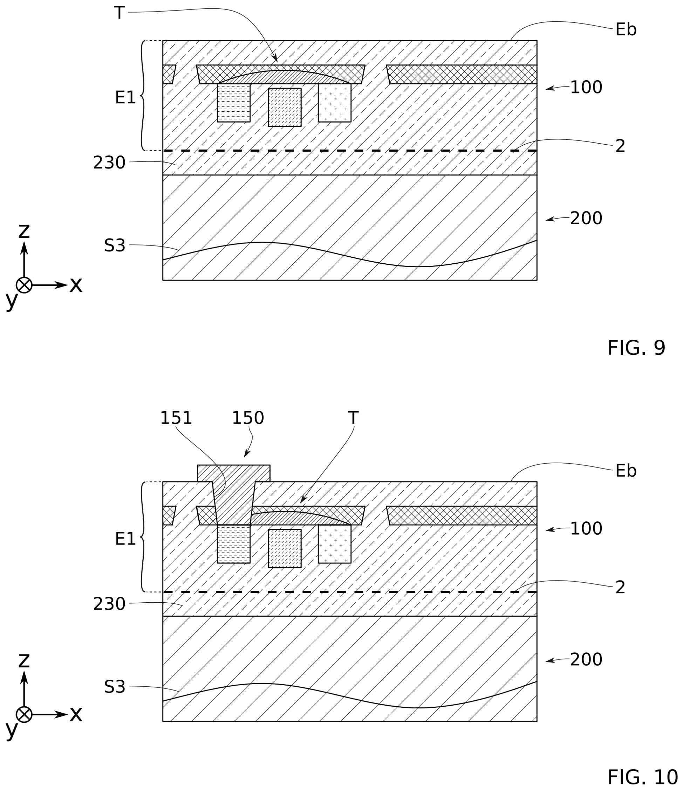

Le report de la première plaque sur la plaque de support, permet de manipuler une face arrière Eb de l'empilement E1. Pour cela, comme illustré à la figure 9, le substrat S1 peut être retiré suite au collage des deux plaques, permettant ainsi d'exposer la face arrière Eb de l'empilement E1. Cela facilite l'accès aux couches de l'empilement E1, notamment la couche active E12, sans devoir traverser le substrat S1 qui peut présenter une épaisseur importante de l'ordre de plusieurs centaines de micromètres. Le substrat peut être retiré par exemple par une gravure chimique et/ou par abrasion.

Comme illustré à la figure 10, suite au retrait du substrat, un réseau d'alimentation 150 peut être fabriqué sur la face arrière Eb de l'empilement E1. Ce réseau d'alimentation est connu sous le terme « Back-Side Power Delivery Network » (BS-PDN) du fait qu'il est formé sur la face arrière. Le réseau d'alimentation 150 peut comprendre par exemple des vias 151 traversant l'empilement E1 jusqu'aux sources Ts, drains Td, et grilles Tg des transistors T. La formation du réseau d'alimentation sur la face arrière de l'empilement, permet d'économiser de l'espace latéral, c'est-à-dire dans le plan xy, et par conséquent d'augmenter la densité de transistors au sein de l'empilement. La réduction des distorsions à l'aide du procédé de la présente invention, permet de faciliter la formation du réseau d'alimentation 150, qui peut impliquer des étapes de lithographie et d'alignement à l'aide de marqueurs préfabriqués dans l'empilement E1.

Dans les exemples décrits précédemment, les matériaux des deux surfaces de collage 110, 210, sont à base d'oxyde, notamment à base de SiO₂. Le procédé permet de coller des surfaces d'oxydes, e.g. SiO₂/SiO₂, avec une vitesse de collage Vc inférieure à la vitesse de collage de deux surfaces Si/Si hydrophobes. Le collage direct selon ce procédé n'est pas limité aux surfaces 110, 210 à base de SiO₂, et peut être réalisé avec des surfaces de collages à base d'autres oxydes, des nitrures, des semiconducteurs ou des métaux. À titre d'exemple, au moins une des surfaces de collage 110, 210, peut être à base de : Si3N4, SiCN, Al2O3, TaN, TiN, Si, Ge Ti, Ni, Cu, AI, Ta, etc. Le collage peut être un collage hybride, avec des surfaces de collage comprenant des régions de différents matériaux, e.g. des régions oxydes ou des nitrures et des régions métalliques ou semi-conductrices.

Le premier gaz présent dans le plasma et comprenant de fluor peut être du SF₆, du CF₄, du NF3 ou du F2 un autre gaz comprenant du fluor ou un mélange de plusieurs gaz comprenant du fluor. Le deuxième gaz présent dans le plasma peut être un gaz dépourvu de fluor, e.g. N₂, O₂, Ar, He, etc. Le deuxième gaz peut être aussi un mélange de plusieurs gaz. Le premier et deuxième gaz formant le plasma, sont choisis de façon à être adaptés pour la formation d'un plasma.

Le gaz de collage 22 formant l'atmosphère de collage 1, peut être choisi parmi les gaz suivants : He, CO2, N2, O2, Ne, Ar, CF₄, SF₆ F2 et H₂. Le gaz de collage 22 peut être aussi un mélange de plusieurs gaz. De préférence, le gaz de collage est choisi de façon à présenter un parcours libre moyen court ce qui réduit encore la vitesse de l'one de collage (par exemple le CO₂). L'utilisation de l'hélium ,du néon ou de l'hydrogène comme gaz de collage permet de réduire la formation de défauts connus sous « picots » qui résultent du collage et qui sont typiquement observés à la périphérie de la structure finale (généralement sous la forme d'une plaquette circulaire).

Selon un exemple, le procédé peut comprendre en outre, une étape de traitement thermique des surfaces de collage 110, 210, avant de les coller. Ce traitement thermique peut être réalisé avant ou après le transfert des surfaces de collage vers l'équipement de collage 20. Ce traitement thermique peut être mis en œuvre à une température supérieure ou égale à 20°C et/ou inférieure ou égale à 150°C, et de préférence inférieure ou égale à 50°C. Selon un exemple préférentiel, le traitement thermique est réalisé à une température comprise entre 20°C et 50°C. Si le traitement thermique est réalisé avant le transfert vers l'équipement de collage, il faut que le temps entre ce traitement et le collage garantisse que la température des surfaces au moment du collage soit inférieure ou égale à 150 °C et de préférence comprise entre 20 °C et 50 °C.

Un exemple particulier non limitatif de l'application du procédé est décrit ci-après. Deux plaques à coller présentant un diamètre de 300 mm, comprenant des couches de protection en oxyde thermique de 100nm d'épaisseur sont fournies. Les surfaces de collage de ces plaques sont donc à base d'oxyde thermique. Les surfaces de collage sont ensuite nettoyées lors d'un nettoyage préliminaire avec une eau ozonée obtenue en utilisant de l'eau déionisée avec de l'ozone dissous à une concentration de 14 ppm (parties par million), équivalente à 14 mg/L . Les surfaces de collage sont ensuite rincées par l'eau déionisée. Les surfaces de collage sont ensuite traitées par un traitement APM (mélange connu sous le terme « Ammonium Hydroxide-Hydrogen Peroxide Mixture ») en utilisant une solution composée de trois composants principaux, à savoir : hydroxyde d'ammonium, peroxyde d'hydrogène et de l'eau déionisée, le rapport des trois composants étant de 1-1-5 à 70°C dans la solution de nettoyage. Les surfaces de collage sont ensuite gravées très légèrement dans un bain d'acide fluorhydrique (HF) à une concentration massique de 0,1% pendant 30 s, puis rincées à nouveau par l'eau déionisée. Chacune des précédentes sous-étapes de nettoyage préliminaire peut durer environ 10 minutes (sauf celle de HF).

Suite au nettoyage préliminaire des surfaces de collage, les plaques sont introduites dans un équipement EVG^{®}850 LT. Les surfaces de collage sont ensuite nettoyées une deuxième fois à l'aide d'un appareil Megpie^{®} fonctionnant à 90 W et à 30 RPM (révolutions par minute) pendant une minute. Ce deuxième nettoyage utilise une solution d'ammoniac à 2 % dans de l'eau déionisée. Cela permet d'éliminer efficacement les contaminants particulaires des surfaces de collage.

Les surfaces de collages sont ensuite traitées par le plasma fluoré comprenant un premier gaz de CF₄ avec un pourcentage atomique F=0,4% et un deuxième gaz d'oxygène. Le traitement par le plasma fluoré peut être réalisé à des fréquences de 47 KHz et de 347 KHz, et peuvent durer environ 15 secondes. Les deux plaques sont ensuite transférées directement à la chambre de collage, en passant par l'atmosphère de la salle blanche caractérisée par une humidité relative de 45% et une température ambiante de 21°C. L'atmosphère de collage est ensuite formée en injectant un gaz de collage d'He jusqu'à atteindre une humidité relative RH de la chambre de collage inférieure à 2%. Le collage des deux surfaces est ensuite mis en œuvre sous l'atmosphère de collage sèche. Le collage peut être initié par une pression localisée, de préférence au centre des plaques, qui peut être de l'ordre de 3500 mN. L'onde de collage se propage à partir du centre à une vitesse de collage Vc inférieure à 15 mm/s et plus préférentiellement inférieure à 10 mm/s.

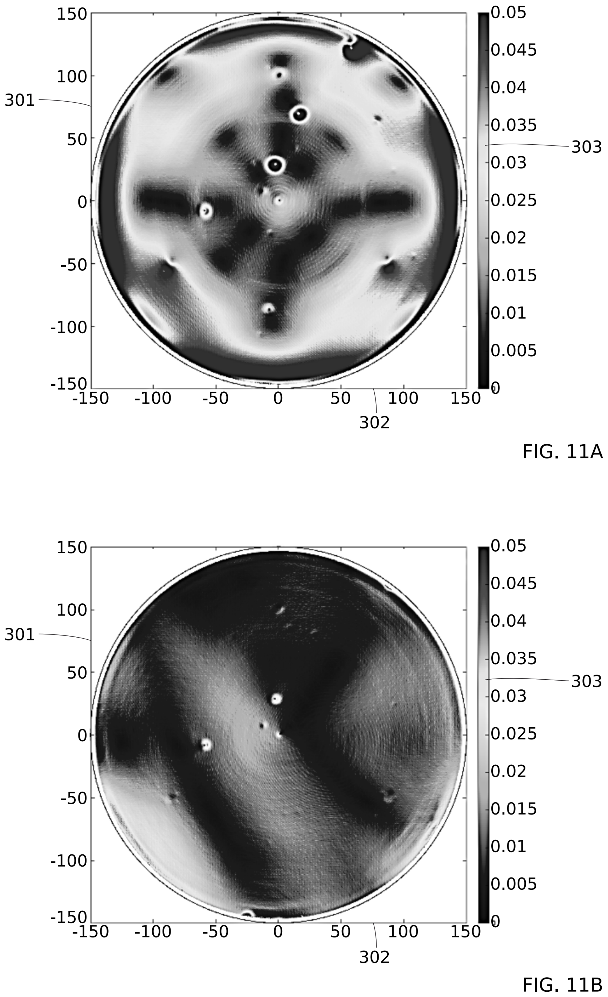

Les figures 11A et 11B, illustrent des cartographies des déplacement dans le plan (IPD ou « In-plane displacement ») obtenue à l'aide d'analyses interférométriques des assemblages obtenues par collage direct. Ces cartographies représentent une empreinte des déformations des plaques dues au collage direct. La figure 11A représente une cartographie IPD d'un assemblage obtenu par collage direct de deux plaques sous conditions standards, notamment avec une vitesse de collage standard (de l'ordre de 30 mm/s). Les axes des abscisses 302 et d'ordonnées 303, représentent la distance en millimètres (mm) du centre des plaques suivant les directions x et y, respectivement. L'échelle de couleur 303 représente les déformations post-collage des plaques mesurées en micromètres suivant une direction z. La figure 11B représente une cartographie IPD d'un assemblage obtenu par collage direct de deux plaques suivant l'exemple particulier décrit précédemment, notamment pour une vitesse de collage réduite inférieure à 15 mm/s et plus préférentiellement inférieure à 10 mm/s. La comparaison des deux cartographies montre clairement la réduction significative des distorsions résultant d'un collage direct à une vitesse de collage réduite. Ce résultat prouve l'efficacité d'un collage de surfaces traitées par un plasma fluoré et collées sous atmosphère sèche, dans la réduction des distorsions.

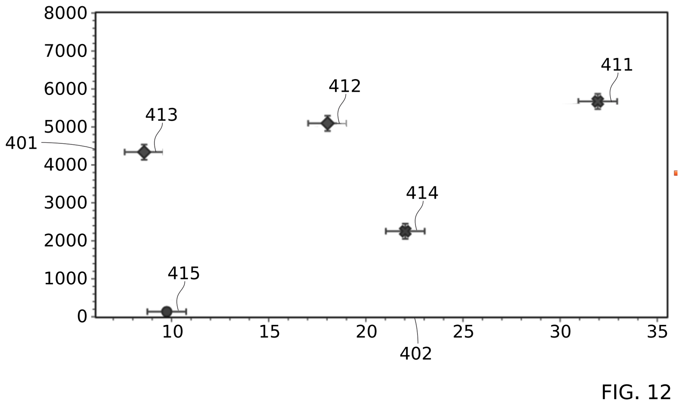

La figure 12 illustre un graphe dans lequel l'axe des abscisses 401 représente la vitesse de collage Vc mesurée en mm/s, et l'axe des ordonnées 402 représente l'énergie d'adhérence mesurée en mJ/m² après un recuit à 300°C. Dans ce graphe, différents points 411 à 415 sont classés. Ces points représentent les énergies d'adhérence obtenues pour différentes vitesses de collage, lors de différents cas de collage direct de plaques. Les points 414 et 415 dans la partie inférieure du graphe correspondent à des collages directs réalisés sans traitement des surfaces par du plasma fluorée et dans une atmosphère de collage standard (RH entre 45% et 50%). L'énergie d'adhérence obtenue pour ces deux cas n'est pas assez élevée car les surfaces de collage n'ont pas été traitées par du plasma fluoré avant le collage. Le cas 415 correspond à un collage de surfaces hydrophobes. Pour des surfaces de collage hydrophobes, la vitesse de collage est relativement faible (~10 mm/s). Les points 411, 412 et 413 dans la partie supérieure du graphe correspondent à des collages directs de surfaces qui ont subi un traitement par un plasma fluoré. Le cas 411 correspond à un collage direct de deux plaques pour F₄₁₁=0,4 et pour RH₄₁₁~50%, donnant lieu à une énergie d'adhérence optimale de l'ordre de 5800 mJ/m² et à une vitesse de collage élevée de l'ordre de 32 mm/s. Le cas 412 correspond à un collage direct ayant les mêmes paramètres que le cas 411, i.e. F₄₁₂=0,4 et pour RH₄₁₂~50%, dans lequel les surfaces de collage n'ont pas été nettoyées après le traitement par le plasma fluoré. L'omission du nettoyage des surfaces de collage après le traitement par le plasma fluoré permet de diminuer la vitesse de collage jusqu'à peu près 18 mm/s. En revanche, cette diminution de Vc est accompagnée d'une légère diminution de l'énergie d'adhérence. Enfin, le cas 413 correspond à un collage selon le procédé de la présente demande, dans lequel les surfaces ont été traitées par un plasma avec F₄₁₃=0,4% et collées sous une atmosphère sèche présentant une humidité relative RH₄₁₃~0%. Pour ce dernier cas, la vitesse de collage est réduite jusqu'à peu près 9 mm/s et l'énergie d'adhérence est autour de 4200 mJ/m² ce qui est suffisant pour obtenir une bonne adhérence des surfaces, montrant ainsi l'efficacité du présent procédé de collage direct.

On donne ci-après un exemple de valeurs pouvant être employées, de préférence en combinaison, pour mettre en œuvre l'invention, sans caractère limitatif :
Concentration atomique de F dans le plasma : 4 %
Atmosphère de collage 40 % RH
Vitesse de l'onde de collage 6 mm/s
Energie de collage : 1900 mJ/m² à 100 °C (ce qui représente un très bon résultat pour cette température).

L'invention n'est pas limitée aux modes de réalisation précédemment décrits et s'étend à tous les modes de réalisation couverts par l'invention. Différents exemples particuliers du procédé de collage direct ont été décrits. D'autres variantes de réalisation sont possibles, par exemple par combinaison de caractéristiques précédemment décrites, sans se départir du principe de la présente invention. En outre, les caractéristiques décrites relativement à un aspect de l'invention peuvent être combinées à un autre aspect de l'invention.

## Revendications

1. Procédé de collage direct d'un premier dispositif microélectronique (100) sur un deuxième dispositif microélectronique (200) comprenant les étapes suivantes :
• une fourniture d'un premier dispositif microélectronique (100) présentant une première surface (110) plane, et d'un deuxième dispositif microélectronique (200) présentant une deuxième surface (210) plane,
• un traitement d'au moins l'une parmi les première (110) et deuxième (210) surfaces par un gaz de plasma comprenant au moins un premier gaz fluoré, présentant un pourcentage atomique F de fluor,
• un transfert des premier (100) et deuxième (200) dispositifs vers un équipement de collage (20),
• une immersion des première (110) et deuxième (210) surfaces dans une atmosphère de collage (1) présentant une humidité relative RH contrôlée,
• un collage des première (110) et deuxième (210) surfaces disposées l'une en regard de l'autre, à l'aide de l'équipement de collage (20) sous l'atmosphère de collage (1), dans lequel une adhésion partielle des première (110) et deuxième (210) surfaces est initiée et se propage sous forme d'une onde de collage à une vitesse Vc dite vitesse de collage,
le procédé étant **caractérisé en ce que** le pourcentage atomique F de fluor lors de l'étape de traitement, et l'humidité relative RH lors de l'étape de collage, sont contrôlés en synergie de sorte que la vitesse de collage Vc soit inférieure ou égale à 15 mm/s.

2. Procédé de collage direct selon la revendication précédente, dans lequel le transfert des premier (100) et deuxième (200) dispositifs vers l'équipement de collage (20) est réalisé directement après le traitement par le gaz de plasma sans passer par une étape de nettoyage intermédiaire.

3. Procédé de collage direct selon l'une quelconque des revendications précédentes, dans lequel le traitement par le gaz de plasma est opéré sur chacune des première (110) et deuxième (210) surfaces avec un même gaz plasma.

4. Procédé de collage direct selon l'une quelconque des revendications précédentes, dans lequel l'humidité relative RH est supérieure ou égale à 0% et inférieure à 45%.

5. Procédé de collage direct selon la revendication précédente, dans lequel l'humidité relative RH est inférieure ou égale à 2%.

6. Procédé de collage direct selon l'une quelconque des revendications précédentes, dans lequel le pourcentage atomique F de fluor est supérieur ou égal à 0,4%.

7. Procédé de collage direct selon l'une quelconque des revendications précédentes, dans lequel le pourcentage atomique F de fluor est inférieur ou égal à 4%.

8. Procédé de collage direct selon l'une quelconque des revendications précédentes, dans lequel :
• l'équipement de collage (20) comprend une chambre de collage (21) dans laquelle les premier (100) et deuxième (200) dispositifs sont insérés lors de l'étape de transfert, et
• l'immersion des première (110) et deuxième (210) surfaces dans l'atmosphère de collage (1) comprend une injection d'un flux d'un troisième gaz (22) dit de collage dans la chambre de collage (21), de sorte que le gaz de collage (22) soit confiné dans la chambre de collage (21) formant ainsi l'atmosphère de collage (1).

9. Procédé de collage direct selon l'une quelconque des revendications 1 à 7, dans lequel l'immersion des première (110) et deuxième (210) surfaces dans l'atmosphère de collage (1) comprend une injection d'un flux d'un troisième gaz (22) dit de collage de sorte que le gaz de collage (22) remplisse au moins une région (1') entre les première (110) et deuxième (210) surfaces disposées l'une en regard de l'autre, formant ainsi l'atmosphère de collage (1).

10. Procédé de collage direct selon l'une quelconque des revendications précédentes en combinaison avec la revendication 8 ou 9, dans lequel le gaz de collage (22) consiste en, ou est un mélange comprenant au moins un des gaz suivants : He, CO2, N2, O2, Ne, Ar, CF₄, SF₆, NF3, F2 et H₂.

11. Procédé de collage direct selon l'une quelconque des revendications précédentes, dans lequel le premier gaz consiste en, ou est un mélange comprenant au moins un des gaz suivants : SF₆, CF₄, NF3 et F2.

12. Procédé de collage direct selon l'une quelconque des revendications précédentes, comprenant en outre un traitement thermique des première (110) et deuxième (210) surfaces avant le collage, le traitement permet de porter les première (110) et deuxième (210) surfaces à une température supérieure ou égale à 20°C et/ou inférieure ou égale à150°C.

13. Procédé de collage direct selon l'une quelconque des revendications précédentes, dans lequel :
• le premier dispositif (100) est une plaque comprenant un premier empilement (E1), ledit premier empilement (E1) comprenant au moins un transistor (T) et étant en contact avec la première surface (110), et
• le deuxième dispositif (200) est une plaque comprenant un deuxième empilement (E2), ledit deuxième empilement (E2) comprenant au moins un transistor (T) et étant en contact avec la deuxième surface (210).

14. Procédé de collage direct selon l'une quelconque des revendications 1 à 12, dans lequel :
• le premier dispositif (100) est une plaque comprenant un premier empilement (E1) sur un substrat (S1), ledit premier empilement (E1) comprenant au moins un transistor (T) et étant en contact avec la première surface (110), le substrat (S1) étant destiné à être retiré suite au collage, et
• le deuxième dispositif (200) est une plaque comprenant au moins une couche de support (230) en contact avec la deuxième surface (210).

15. Procédé de collage direct selon l'une quelconque des revendications précédentes, dans lequel au moins l'une des première (110) et deuxième (210) surfaces est à base d'un matériau semiconducteur, ou d'un oxyde, ou d'un nitrure, ou d'un métal, ou encore comprend au moins une zone à base d'un oxyde ou d'un nitrure et une zone à base d'un métal ou d'un semiconducteur.
